# FASCICULE DE BREVET EUROPEEN

(11) **EP 1 473 765 B1**
(45) Date de publication et mention de la délivrance du brevet: **05.06.2013**
(21) Numéro de dépôt: 04291100.8
(22) Date de dépôt: 29.04.2004
(51) Int. Cl.: H01L 21/762, H01L 21/20, H01L 21/02

(54) **Traitement par brossage d'une plaquette semiconductrice avant collage**
Bürsten einer Hableiterscheibe vor dem Kleben
Semiconductor wafer treatment by brushing before bonding

(30) Priorité: 29.04.2003 FR 0305236
(43) Date de publication de la demande: 03.11.2004
(73) Titulaire: Soitec, 38190 Bernin (FR); Commissariat à l'Énergie Atomique et aux Énergies Alternatives, 75015 Paris (FR)
(72) Inventeur: Maleville, Christophe, 38660 La Terrasse (FR); Maunand, Tussot Corinne, 38240 Meylan (FR); Kerdiles, Sébastien, 38330 St Ismier (FR); Rayssac, Olivier, 38100 Grenoble (FR); Scarfogliere, Benjamin, 38100 Grenoble (FR); Moriceau, Hubert, 38120 Saint Egreve (FR); Morales, Christophe, 38100 Le Pont de Claix (FR)
(74) Mandataire: Regimbeau

(56) Documents cités:
- EP-A- 0 969 500
- US-A- 5 131 968
- US-A- 5 374 564
- US-A- 5 994 207
- SPIERINGS G A C M ET AL: "Surface-related phenomena in the direct bonding of silicon and fused-silica wafer pairs" PHILIPS JOURNAL OF RESEARCH, ELSEVIER, AMSTERDAM, NL, vol. 49, no. 1, 1995, pages 47-63, XP004011506 ISSN: 0165-5817

## Description

La présente invention concerne le collage de deux plaquettes comprenant des matériaux semiconducteurs afin de réaliser des structures pour la microélectronique, l'optique ou l'optoélectronique.

L'invention concerne plus précisément la préparation des surfaces de collage des deux plaquettes à coller.

Afin d'obtenir un bon collage des deux plaquettes, il est nécessaire de nettoyer les surfaces à coller avant le collage.

Il est connu, par exemple, de faire subir aux plaquettes un ou des traitements chimiques, tel qu'un traitement RCA, apte à enlever des particules isolées et des contaminants métalliques et organiques.

Une autre technique connue de traitement chimique de surface est un nettoyage à base d'ozone sec obtenu par transformation d'oxygène atmosphérique en ozone sous l'action de rayons UV : l'ozone sec ainsi obtenu va alors réagir avec des contaminants hydrocarbures de surface, et en éliminer par création d'espèces volatiles.

D'autres techniques de préparation des surfaces des plaquettes à coller sont de type mécanique et sont mises en oeuvre par des moyens aptes à exercer des forces de frottement sur les surfaces des plaquettes afin d'y retirer des particules isolées.

Des polissages légers ou des brossages peuvent par exemple être mis en oeuvre.

En outre de l'absence de résidus particulaires, organiques et de défauts superficiels, la qualité du collage entre les plaquettes dépend de la technique d'adhésivité mise en oeuvre pour coller les plaquettes, l'adhésivité entre deux plaquettes pouvant au moins, dans un premier temps, être trouvée par adhésion moléculaire.

Des traitements particuliers préliminaires au collage seront avantageusement mis en oeuvre pour améliorer cette adhésion moléculaire des deux plaquettes (et donc la qualité du collage).

EP 0 969 500 (5/01/2000) décrit un procédé de collage de deux plaquettes semiconductrices comprenant une étape de nettoyage chimique et un brossage final pour retirer les particules.

US 5 131 968 (21/07/1992) décrit un appareil et un procédé d'amélioration de collage de plaquettes semiconductrices, par brossage, séchage, alignement et mise en contact des plaquettes pour le collage.

L'amélioration de l'adhésion correspond habituellement à une augmentation de la tenue mécanique et/ou à un accroissement de la qualité de l'interface de collage.

Ainsi, on peut obtenir une augmentation de la tenue mécanique entre les plaquettes lors du collage, en rendant au préalable les surfaces de collage d'avantage hydrophiles (se référer par exemple au document intitulé « Proceedings of the 2nd International Conference on Materials for Microelectronics », IOM Communications, p.183, 1998, de O. Rayssac et Coll.).

On sait par exemple que la préparation des plaquettes avant collage avec des solutions chimiques, telles q'une solution ozonée ou une solution contenant un mélange d'acide sulfurique et d'eau oxygénée (encore appelée solution SPM (acronyme anglo-saxon de « Sulfuric Peroxide Mixture »)), facilite l'enlèvement des contaminants hydrocarbures mais aussi la mouillabilité à la surface des plaquettes en augmentant l'hydrophilie, et augmente donc l'énergie de collage.

De façon plus générale, des solutions de type RCA sont utilisées, en outre pour leur fonction de nettoyage, pour augmenter l'hydrophilie des surfaces destinées à être collées par adhésion moléculaire.

Après cette action chimique, au moins une des surfaces de collage peut en outre être exposée à un plasma afin d'accroître les forces qui vont lier les deux plaquettes lors de leur mise en contact, la mise en contact étant alors éventuellement accompagnée ou suivie d'un traitement thermique de renforcement de collage. On se reportera à ce sujet à l'article de T. Suni et Coll. (Journal of Electromechanical Society 149, G348, 2002, « Effects of plasma activation on hydrophilic bonding of Si and SiO2 »).

De façon différente, un polissage mécano-chimique, tel qu'une planarisation mécano-chimique encore appelée CMP (acronyme anglo-saxon de « Chemical Mechanical Planarization »), peut permettre d'activer des surfaces de collage s'il est mis en oeuvre dans un certain milieu chimique.

Ainsi, par exemple, une CMP en milieu basique sur des surfaces de Si ou de SiO₂ peut activer ces surfaces de sorte à renforcer leurs adhésions moléculaires une fois celles-ci en contact l'une avec l'autre, tel que notamment décrit par R. Stengl, T. Tang et U. Gosële (Jpn. J. Appl. Phys., 28, p.1735, 1989). Une étape de brossage peut optionnellement être ensuite mise en oeuvre afin d'éliminer des particules résultant du polissage.

Cependant, un polissage même léger conserve un caractère abrasif qui peut porter atteinte à la qualité du matériau ainsi traité.

Ainsi, les traitements précédemment discutés ne sont quelquefois pas suffisants, notamment si :
- ils sont suivis d'autres traitements diminuant les propriétés de qualité et/ou d'activation de surface acquise ;
- un temps d'attente important les sépare d'avec l'étape de collage, pouvant provoquer des contaminations et des dépôts de résidus gazeux en atmosphère.

La présente invention tend à améliorer cette situation en proposant selon un premier aspect un procédé de collage de deux plaquettes au niveau de deux surfaces de collage respectives, pour une application dans le domaine de l'électronique, de l'optique et de l'optoélectronique selon la revendication 1.

Selon un deuxième aspect, l'invention propose un procédé de prélèvement d'une couche en matériau choisi parmi les matériaux semiconducteurs à partir d'une plaquette donneuse, caractérisé en ce qu'il comprend les étapes suivantes :
(a) formation d'une zone de fragilisation dans la plaquette donneuse à une profondeur déterminée correspondant sensiblement à une épaisseur de couche mince ;
(b) activation d'une surface de la plaquette donneuse et/ou d'une plaquette réceptrice au moyen d'un brossage ;
(c) collage de la plaquette avec la plaquette réceptrice donneuse au niveau des ou de la surface(s) activée(s) ;
(d) apport d'énergie au niveau de la zone de fragilisation de sorte à détacher de la plaquette donneuse la couche mince collée à la plaquette réceptrice.

Des caractéristiques préférées du procédé de prélèvement d'une couche sont :
- l'étape (a) est mise en oeuvre par l'une des deux techniques suivantes :
   √ implantation d'espèces atomiques à une profondeur voisine de la profondeur de la zone de fragilisation ;
   √ porosification d'une couche au niveau de la zone de fragilisation ;
- avant l'étape (b) est mise en oeuvre une étape de formation d'une couche de collage sur au moins une des deux surfaces de collage ;
- le collage de la plaquette donneuse avec la plaquette réceptrice est accompagné ou suivi d'un traitement thermique apte à augmenter les liaisons de collage entre les deux plaquettes ;
- entre l'étape (a) et l'étape (b), est mise en oeuvre au moins une étape de nettoyage et/ou d'activation de la surface.

D'autres aspects, buts et avantages de l'invention sont décrits dans la suite de ce document en illustration des figures suivantes :
La figure 1 représente schématiquement un dispositif de brossage d'une surface d'une plaquette.
La figure 2 représente un graphe comparatif de l'efficacité de nettoyage de la surface d'une plaquette en silicium massif sans brossage et avec brossage.
La figure 3 représente un graphe comparant l'efficacité de nettoyage de la surface d'une plaquette en silicium recouverte d'oxyde sans brossage et avec brossage.
La figure 4 représente une technique de mesure d'une énergie de collage de deux plaquettes.
La figure 5 présente une comparaison graphique de deux énergies moyennes de collage de deux plaquettes respectivement après brossage et sans brossage des surfaces collées, antérieurement au collage.
La figure 6 représente un graphe comparatif d'énergies de collage mesurées entre des plaquettes ayant préalablement subi un traitement par plasma et un collage selon qu'est mis ou non en oeuvre un brossage entre le traitement plasma et le collage, l'énergie de collage étant en fonction des puissances RF choisies lors du traitement plasma.

Un but principal de la présente invention est d'améliorer le collage entre deux plaquettes, notamment en atteignant les deux objectifs suivants :
- enlever des particules isolées en surface d'une plaquette à coller, et en particulier des contaminants chimiques en surface de la plaquette afin notamment d'améliorer l'hydrophilie ;
- activer la surface de la plaquette afin de faciliter l'adhésion moléculaire des deux plaquettes lors du collage.

Un autre but est la possibilité d'atteindre ces deux objectifs au moyen d'une technique simple, rapide et économique.

Un autre but est de mettre en oeuvre des étapes de préparation des plaquettes qui permettent d'activer la surface de la plaquette de façon plus importante que dans l'état de la technique.

Pour ce faire, l'invention présente un procédé de préparation d'une surface d'une ou de deux plaquettes au collage, mettant en oeuvre au moins une étape de brossage d'au moins une surface de collage.

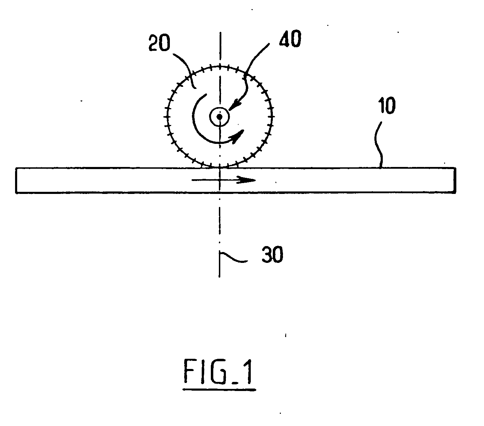

En référence à la figure 1, il est présenté un dispositif de brossage d'une plaquette 10 destinée au collage.

La plaquette 10 est maintenue de façon stable et est apte à être mise en rotation autour d'un axe 30 sensiblement perpendiculaire à la surface de la plaquette.

Une brosse 20, ayant une forme typiquement cylindrique, est apte à être mise en rotation autour d'un axe 40 sensiblement perpendiculaire à l'axe 30.

La brosse 20 est en outre avantageusement munie d'une matière texturée, telle qu'un polymère, sur sa surface périphérique destinée à venir en contact léger avec la surface de la plaquette 10.

De façon préférentielle, une injection d'espèces chimiques adaptées ou d'eau ultra pure sur la surface de la plaquette accompagne le brossage, pouvant par exemple être mise en oeuvre au travers d'une cavité traversante pratiquée au niveau de l'axe 40 et/ou par des jets envoyés au-dessus de la brosse 20.

La plaquette 10 est mise en rotation autour de l'axe 30 tandis que la brosse 20 est mise en rotation autour de l'axe 40.

Ainsi l'action de la brosse 20 sur la surface de la plaquette 10 est faite de manière uniforme sur toute la surface de la plaquette 10.

Et on a donc un enlèvement des particules en surface de la plaquette, uniforme.

Avant le brossage et selon l'invention un traitement par plasma est réalisé. Le traitement par plasma permet notamment d'activer la surface de collage de la plaquette 10, notamment lorsque le futur collage s'accompagne ou est suivi d'un traitement thermique.

Ainsi, on pourra exposer la surface à des plasmas à base d'oxygène, d'azote, d'argon ou autres.

Les équipements utilisés à cet effet peuvent entre autres être initialement prévus pour des gravures ioniques réactives RIE (acronyme anglo-saxon de « Reactive Ion Etching ») à couplage capacitif, ou à couplage inductif ICP (acronyme anglo-saxon de « Inductively Coupled Plasma »). Pour plus de précisions, on pourra par exemple se référer au document de Sanz-Velasco et Coll. intitulé « Room temperature wafer bonding using oxygen plasma treatment in reactive ion etchers with and without inductively coupled plasma » (Journal of Electrochemical Society 150, G155, 2003).

D'autres équipements à plasma atmosphérique, ou encore munis d'une source de type ECR (abréviation anglo-saxonne de « Electron Cyclotron Resonance ») ou de type helicon, ou d'autres peuvent aussi être utilisés.

Ces plasmas peuvent en outre être plongés dans un champ magnétique, notamment pour éviter des diffusions d'espèces électriquement chargées vers les parois du réacteur, grâce à des équipements de type MERIE (acronyme anglo-saxon de « Magnetically Enhanced Reactive Ion Etching »).

La densité du plasma peut être choisie faible, moyenne ou forte (ou « HDP » de l'acronyme anglo-saxon « High-Density-Plasma »).

Dans la pratique, l'activation de collage par plasma comprend en général au préalable un nettoyage chimique, tel qu'un nettoyage RCA, suivi de l'exposition de la surface avec un plasma pendant quelques secondes à quelques minutes.

Optionnellement, des nettoyages postérieurs à l'exposition plasma peuvent être mis en oeuvre, notamment pour retirer les contaminants introduits lors de l'exposition, tels qu'un rinçage à l'eau et/ou un nettoyage SC1, suivis éventuellement de séchage par centrifugation.

Cependant, cette étape optionnelle peut être évitée puisque l'étape ultime de brossage qui sera mise en oeuvre permettra, en elle-même, d'éliminer une partie importante de ces contaminants.

Avant le brossage, sont avantageusement mis en oeuvre un ou plusieurs des traitements suivants, pris individuellement ou en combinaison :
(1) nettoyage chimique humide ;
(2) nettoyage chimique sec ;
(3) polissage mécano-chimique.

Le traitement (1) par nettoyage chimique humide peut être un traitement RCA (comprenant un traitement employant successivement une solution SC1, contenant de l'hydroxyde d'ammonium (NH₄OH), du peroxyde d'hydrogène (H₂O₂) et de l'eau dé-ionisée ; et une solution SC2, contenant de l'acide chlorhydrique (HCl) et du peroxyde d'hydrogène (H₂O₂) et de l'eau dé-ionisée) et/ou des rinçages successifs et/ou des traitements humides ozonés et/ou SPM et/ou d'acide fluorhydrique, ou d'autres solutions aptes à nettoyer et/ou à activer une surface de collage.

On pourra par exemple employer successivement une solution ozonée, un traitement RCA puis une solution ozonée pour traiter la plaquette considérée.

On pourra par exemple employer successivement une solution ozonée, un acide fluorhydrique et une solution ozonée pour traiter la plaquette 10.

L'humidité peut être trouvée en trempant la plaquette 10 dans un bain ou en injectant des gouttelettes sur la plaquette 10.

Optionnellement, sont émises des ondes mégasoniques simultanément au traitement chimique pour aider au retrait de particules isolées sur la surface de collage.

Le traitement (2) par nettoyage sec est principalement destiné à éliminer une contamination en hydrocarbures, individuellement ou en complément ou en alternance de nettoyages humides.

Un nettoyage à sec consiste à volatiliser les hydrocarbures après réaction de ceux-ci avec de l'ozone sec, l'ozone sec étant obtenu en atmosphère à partir de la transformation d'oxygène sous rayonnement UV.

A cet effet, ces rayons UV sont typiquement émis d'une lampe à mercure, pour provoquer la réaction chimique transformant l'oxygène en ozone dans une enceinte appelée ozoneur.

Le traitement (3) est un polissage mécano-chimique tel qu'une CMP.

Une CMP a pour but de planéifier de façon optimale la surface de la plaquette 10, en mettant en oeuvre les trois actions combinées suivantes :
- une attaque mécanique macroscopique de la plaquette 10 grâce à des forces de frottement d'au moins un plateau de polissage sur au moins une face de la plaquette 10 ;
- une attaque mécanique microscopique de la plaquette 10 effectuée par des particules abrasives contenues dans une solution de polissage ;
- une attaque chimique de la plaquette 10 effectuée par un agent chimique contenu dans la solution de polissage.

La combinaison de ces trois actions s'effectue de manière générale simultanément avec un apport d'une solution de polissage contenant les particules abrasives et l'agent chimique pendant que le ou les plateau(x) de polissage frotte(nt) sur la plaquette 10.

Les particules abrasives ont des tailles particulièrement calibrées pour être d'une part suffisamment importantes pour que les particules abrasent convenablement la surface de la plaquette 10 et d'autre part pour qu'elles n'abrasent pas trop la surface, pouvant ainsi créer des dommages superficiels importants, tels que des rayures ou des « trous d'épingle ».

Les particules utilisées pour l'abrasion de surfaces en silicium ont ainsi typiquement des tailles de l'ordre de 0.1 micron.

L'agent chimique ajouté dans la solution de polissage est en général choisi pour créer des réactions chimiques en surface de la plaquette 10 permettant de fragiliser voire de détacher des particules en surface de la plaquette 10 ; il peut ainsi jouer un rôle d'aide supplémentaire à l'action abrasive.

Pour des matériaux tels que le silicium cristallin, la silice (encore notée ici SiO₂), le verre ou le quartz, l'action chimique est prépondérante avec un agent chimique ayant un pH basique, de manière à favoriser l'attaque chimique. On pourra ainsi choisir un agent chimique à base d'ammoniaque.

La CMP, dans un milieu chimique adapté, tel qu'un milieu basique pour les matériaux de surface précités, peut générer des liaisons pendantes conduisant à des liaisons Si-OH en surface.

La CMP peut donc avoir pour effet d'augmenter sensiblement les groupements d'ions OH ⁻ sur la surface polie, et ainsi faciliter les futures adhésions moléculaires avec l'autre surface à coller.

Un surfactant adapté peut optionnellement être injecté pendant ou après polissage pour adoucir les actions abrasives mécanico-chimiques.

Un rinçage peut aussi être prévu après le polissage pour aider à l'évacuation des résidus issus du polissage.

En tous les cas, le brossage qui sera mis en oeuvre après la CMP aidera à évacuer les particules issues de l'action du polissage abrasif, notamment si le brossage se fait avec une injection simultanée d'ammoniaque.

Dans le tableau ci-dessous sont présentés différents procédés préférés de préparation de la plaquette 10 avant collage selon l'invention (classés de A à L), prenant en compte à chaque étape successive un des traitements (1), (2), (3), (4) précités ainsi que ledit brossage. Dans le tableau, chaque étape est associée à un numéro, le numéro correspondant à la place dans le temps de l'étape qui lui est associée dans le procédé considéré, l'étape 3 succédant par exemple à l'étape 2 et précédant l'étape 4.

| Procédé | Nettoyage humide | Nettoyage sec | Polissage méca.-chim. | Traitement plasma | Brossage |
|---|---|---|---|---|---|
| A | | | | | 1 |
| B | 1 | | | | 2 |
| C | | 1 | | | 2 |
| D | 1 | 2 | | | 3 |
| E | | | 1 | | 2 |
| F | 2 | | 1 | | 3 |
| G | 1 | | | 2 | 3 |
| H | 1 et 3 | | | 2 | 4 |
| I | 1 | 3 | | 2 | 4 |
| J | | | 1 | 2 | 3 |
| K | 3 | | 1 | 2 | 4 |
| L | | 3 | 1 | 2 | 4 |

Ces procédés selon l'invention ne sont pas limitatifs : tout traitement mis en oeuvre avant brossage, et susceptible d'améliorer la qualité de la surface traitée et/ou de créer une activation supplémentaire de cette surface peut être mis en oeuvre, pris individuellement ou en combinaison successivement avec d'autres traitements.

En tous les cas, les traitements de surface se terminent par une étape de brossage.

Après le brossage, la plaquette 10 est préférentiellement rincée par rotation, et séchée par centrifugation.

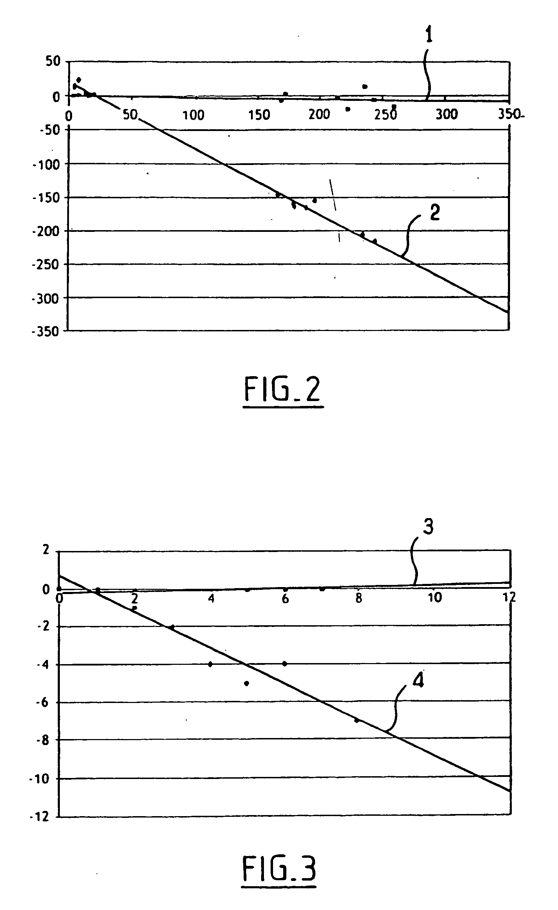

En référence aux figures 2 et 3, la Demanderesse a effectué des mesures de LPD (abréviation de "Light Point Defect") sur les surfaces de différentes plaquettes volontairement polluées à différents taux de pollution.

Un « LPD » est un défaut, qui est encore appelé point brillant, détectable par des mesures optiques de LPD.

Une mesure de LPD consiste à illuminer la surface de la plaquette par une onde optique incidente émise par une source laser, et à détecter au moyen d'un détecteur optique la lumière diffusée par les défauts LPD présents sur la surface.

La diffusion de la lumière au niveau de la surface de la plaquette 10 étant corrélée avec le nombre de particules résiduelles en surface de la plaquette 10, les mesures de la diffusion lumineuse fournissent des informations quant au nombre de ces particules résiduelles.

Les courbes 1, 2, 3, 4 des figures 2 et 3 ont été tracées à partir des mesures de LPD effectuées sur la surface d'une plaquette 10, les mesures effectuées étant représentées sur les graphes par des points carrés ou en losange.

Les abscisses des graphes représentés par les figures 2 et 3 représentent les nombres de particules résiduelles détectées avant de brosser la surface de la plaquette.

On voit ici qu'avant brossage les surfaces des plaquettes sur lesquelles ont été effectuées les mesures ont des taux de pollution, et donc un nombre de particules résiduelles, élevés et différents d'une plaquette à une autre.

Les ordonnées des graphes représentées par les figures 2 et 3 représentent une différence entre le nombre de particules résiduelles détectées après brossage et le nombre de particules résiduelles détectées avant brossage.

La valeur 0 en ordonnée signifie donc un nombre de particules résiduelles identiques avant et après brossage.

En référence à la figure 2, les mesures sont effectuées sur une plaquette 10 en silicium pour des particules résiduelles supérieures à environ 0,08 micromètres.

La courbe 2 représente le nombre de particules résiduelles enlevées après brossage, à comparer avec la valeur 0 en ordonnée.

On voit donc ici que plus les surfaces des plaquettes sont polluées (c'est-à-dire plus les valeurs en abscisse sont élevées), plus le brossage enlève les particules résiduelles et donc diminue la pollution en surface de la plaquette.

En revanche, la courbe 1 renseigne sur le nombre de particules enlevées après un simple rinçage à l'eau ultra pure de la plaquette 10.

On voit ici que le brossage dépollue la surface de la plaquette 10 de manière sensiblement plus importante qu'avec un simple rinçage.

En référence à la figure 3, les mesures sont effectuées sur une plaquette 10 en silicium recouverte d'une couche d'oxyde d'environ 0,2 microns d'épaisseur, sur laquelle sera mis en oeuvre le brossage, pour des particules résiduelles d'une taille supérieure à environ 0,10 micromètres.

On voit ici que le résultat est, qualitativement, sensiblement identique à celui des mesures effectuées sur une plaquette de silicium massif représentée par la figure 2, à un facteur de grandeur près, la courbe 4 représentant les mesures effectuées après brossage et la courbe 3 les mesures effectuées après rinçage.

De ces mesures, la Demanderesse a mis en évidence l'efficacité d'un brossage vis-à-vis d'un simple rinçage, atteignant ainsi le premier objectif de l'invention.

Et ceci, quelle que soit l'épaisseur de la couche ayant sa surface polluée.

Après brossage des deux surfaces de collage de deux plaquettes à coller, les deux plaquettes sont mises en contact intime l'une avec l'autre au niveau de leur surface de collage brossée.

Le brossage de plaquettes en silicium ou de plaquettes oxydées permet ainsi d'éliminer un nombre conséquent de particules de grosse taille et ainsi d'éviter d'avoir des défauts déclassant les plaquettes.

Des plaquettes sont déclassées lorsque la qualité de collage n'est pas suffisante pour obtenir des structures finales non défectueuses.

La mise en contact des deux plaquettes est avantageusement mise en oeuvre juste après le brossage sans étape intermédiaire d'un traitement quelconque.

Le collage des deux plaquettes est réalisé par adhésion de molécules présentes sur les surfaces de collage.

Optionnellement, une ou plusieurs couches de collage, qui peuvent améliorer des propriétés adhésives sous certaines conditions (de températures, de traitement chimique, mécanique, etc.), sont formées sur l'une ou les deux surfaces à coller.

Cette formation de couche(s) de collage est faite avant le brossage, et préférentiellement avant les autres techniques de nettoyage et/ou d'activation éventuellement mises en oeuvre antérieurement au brossage.

Ces couches de collage peuvent par exemple être en SiO₂ (formées par dépôt ou par oxydation thermique), en Si₃N₄ (formée par exemple par dépôt).

Un traitement thermique est alors avantageusement mis en oeuvre pour accroître les forces moléculaires liant les deux plaquettes.

Ce traitement thermique est mis en oeuvre à une ou plusieurs température(s) déterminée(s) et pendant une durée déterminée afin que l'efficacité du collage soit optimum et pour éviter de créer des défauts structurels en superficie de la plaquette.

En apportant de la chaleur, les molécules d'eau présentes en surface de la plaquette donnent naissance à des liaisons Si-OH et à une diffusion de l'eau au voisinage de la surface des plaquettes.

Les liaisons Si-OH d'une surface de collage d'une plaquette se lient via des liaisons hydrogène à la surface de l'autre plaquette, formant ainsi une force de liaison entre les deux plaquettes suffisamment importante pour opérer un collage de ces deux plaquettes ensembles.

Dans des applications ultérieures au collage des plaquettes, des traitements d'enlèvement de matière sont avantageusement mis en oeuvre pour enlever une grande partie d'une des deux plaquettes afin de n'en garder qu'une couche superficielle restant collée sur la deuxième plaquette (cette couche superficielle pouvant alors, par exemple, faire fonction de couche utile pour recevoir des composants électroniques, ou de support de croissance cristalline d'une ou plusieurs autres couches).

Pour réaliser cet enlèvement de matière, on pourra selon une première variante, mettre en oeuvre un procédé dit "etch-back", c'est-à-dire une gravure par l'arrière d'une plaquette jusqu'à n'en garder que la couche superficielle.

Selon une deuxième variante, une énergie, telle qu'une énergie mécanique ou une énergie thermique, ou toute autre forme d'énergie, sera apportée à l'ensemble collé, pour provoquer un détachement au niveau d'une zone de fragilisation présente dans la première plaquette, afin de ne conserver au final que la deuxième plaquette collée à la couche superficielle et détachée de la première plaquette.

La zone de fragilisation est avantageusement formée avant collage et avant les traitements de nettoyage et d'activation de la surface comprenant le brossage, sous la surface à coller de la première plaquette à une profondeur déterminée, par une des deux techniques suivantes :
- implantation d'espèces atomiques, tels que des ions hydrogène, à un dosage et à une énergie déterminés ;
- porosification formant la zone de fragilisation sur laquelle est formée par épitaxie une couche mince, l'ensemble formant la plaquette dont la surface de collage est la surface de la couche mince.

Dans le cas où une zone de fragilisation est formée par implantation d'espèces atomiques, un traitement thermique est avantageusement réalisé après le collage.

Un traitement thermique ou recuit peut par exemple s'effectuer à une température d'environ 500°C, afin de renforcer les liaisons de collage en créant des liaisons covalentes Si-O-Si entre les surfaces collées.

Optionnellement, un pré-traitement thermique ou pré-recuit est mis en oeuvre avant le recuit.

Après l'étape d'enlèvement de matière, une finition de la surface de la couche détachée collée à la deuxième plaquette est avantageusement mise en oeuvre telle qu'une gravure chimique, une oxydation sacrificielle, un polissage, une planarisation mécano chimique CMP, un bombardement d'espèces atomiques, ou autre technique de lissage.

La structure finale constituée de la seconde plaquette collée à la couche détachée est alors destinée à une application pour la microélectronique, l'optique ou l'optoélectronique.

On pourra par exemple former des composants dans la couche détachée collée à la deuxième plaquette.

On peut ainsi réaliser des structures SeOI (acronyme anglo-saxon de "Semiconductor On Insulator"), telles que des structures : SOI (acronyme anglo-saxon de "Silicon On Insulator"); SGOI (acronyme anglo-saxon de "Silicon-Germanium On Insulator") ; SOQ (acronyme anglo-saxon de "Silicon On Quartz") ; GeOI (acronyme anglo-saxon de "Germanium On Insulator"); alliages constitués de composants appartenant à la famille III-V, sur isolant ; chacune ayant une couche isolante telle que par exemple du SiO₂ ou du Si₃N₄ intercalée entre la couche détachée et la deuxième plaquette.

Cette couche isolante a pu être formée avant collage et avant les étapes de nettoyage et d'activation des surfaces, sur au moins une des deux surfaces à coller. Dans un cas de figure avantageux, sa structure particulière a permis de faciliter les forces d'adhésion lors du collage et du traitement thermique, lui donnant ainsi un rôle supplémentaire (en outre d'être isolante) de couche de collage.

On pourra aussi par exemple réaliser des transistors et des MEMs.

La présente invention concerne une préparation de surfaces de plaquettes en tout type de matériau concernant le domaine des semiconducteurs, c'est à dire des matériaux appartenant à la famille atomique IV, tels que le silicium ou l'alliage silicium - germanium, mais s'étend aussi à d'autres types d'alliages de famille IV-IV, III-V, II-VI ; les surfaces de collage peuvent en outre être en matériau isolant, tel que par exemple du SiO₂, du Si₃N₄.

Dans les couches de semiconducteur présentées dans ce document, d'autres constituants peuvent y être ajoutés, tels que des dopants ou du carbone avec une concentration de carbone dans la couche considérée sensiblement inférieure ou égale à 50 % ou plus particulièrement avec une concentration inférieure ou égale à 5 %.

Il est à préciser que ces alliages peuvent être binaires, ternaires, quaternaires ou de degré supérieur.

### Exemple 1 :

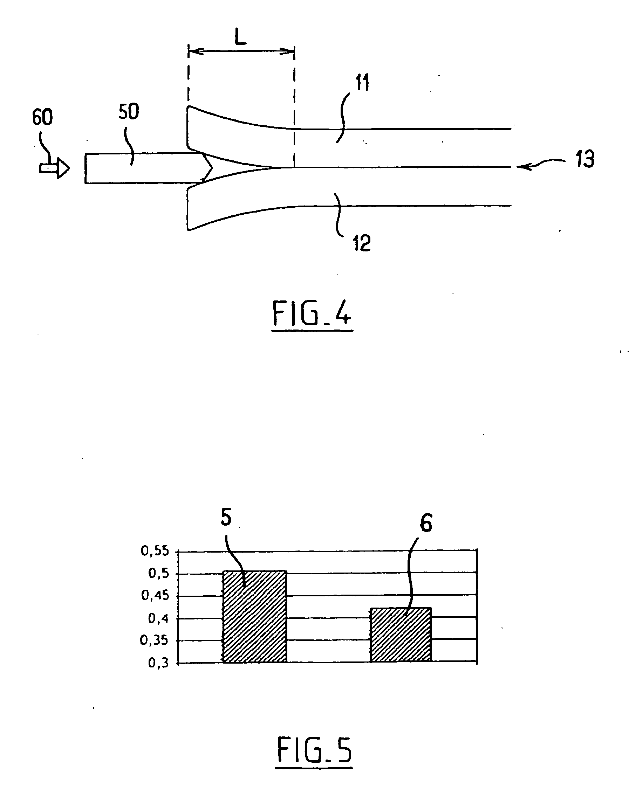

En référence aux figures 4 et 5, la Demanderesse a mesuré l'énergie de collage moyenne entre les deux plaquettes après que leurs surfaces aient subi ou non un simple brossage, puis une mise en contact et enfin un traitement thermique.

La mesure de l'énergie de collage étant associée à la qualité du collage, la Demanderesse a mis en évidence l'influence du brossage sur la qualité du collage.

Pour effectuer ces mesures, la Demanderesse a utilisé une technique précise de caractérisation de tenue de collage proposée par W. P. Maszara (« journal electrochem. soc. », vol 38, n°1, p.341 (1998)).

En référence à la figure 4, la Demanderesse a ainsi inséré une lame d'épaisseur 50 sur un ou plusieurs bords de l'ensemble des plaquettes 11 et 12 collées et au niveau de l'interface de collage 13.

L'application d'une force 60 dans une direction sensiblement parallèle au plan de l'interface 13, sur la lame au niveau de l'interface de collage provoque localement une zone décollée entre les deux plaquettes 11 et 12 et une propagation de la zone décollée sur une certaine longueur L, la longueur L parcourue par l'onde de décollement entre la zone localement décollée par la lame et l'arrêt du décollement nous renseigne alors sur l'énergie de collage qui existe entre les deux plaquettes.

Et ainsi, plus la longueur L de la zone décollée est importante, moins l'énergie de collage est forte.

En effet, la fin du décollement correspond à un équilibre entre l'énergie de collage et la déformation élastique caractérisant le décollement.

On retrouve ainsi, à partir de la longueur L mesurée de la zone décollée, l'énergie de collage moyenne.

Les mesures de l'énergie de collage ont été réalisées et répétées un nombre de fois suffisant pour être validées.

Chaque mesure a été effectuée de façon sensiblement identique aux autres mesures, et en particulier les applications de la lame à l'interface des plaquettes collées ont été faites en exerçant des forces sensiblement identiques et dans une direction sensiblement identique et avec une lame sensiblement identique.

Pour la fiabilité de ces mesures, il est en outre important de s'assurer que la qualité de collage est essentiellement due à l'énergie de collage entre les deux plaquettes et n'est pas perturbée par la présence de particules résiduelles entre les plaquettes.

C'est pourquoi, avant les mesures d'énergie de collage, la Demanderesse a effectué des nettoyages efficaces des surfaces des plaquettes à coller.

En référence à la figure 5, sont présentés les résultats des mesures avec en ordonnée les énergies de collage en joules par mètre carré.

La colonne 5 représente l'énergie de collage mesurée après brossage.

La colonne 6 représente l'énergie de collage mesurée sans qu'il y ait eu de brossage.

On voit ici que le brossage en lui-même augmente l'énergie de collage entre les plaquettes d'environ 20% par rapport à des plaquettes collées n'ayant subi aucun brossage antérieurement.

Le fait de brosser les plaquettes juste avant de les coller conduit à une amélioration du collage indépendamment de la présence ou de l'absence de particules résiduelles sur la surface des plaquettes.

Le fait de brosser les surfaces des plaquettes à coller élimine une grande partie des contaminants de la surface et active des liaisons Si-OH, ce qui provoque une activation, typiquement électro-chimique, des surfaces de collage, et augmente donc de façon sensible les forces de collage des surfaces de collage.

Ainsi la Demanderesse a non seulement mis en évidence l'efficacité de nettoyage par brossage sur les surfaces à coller mais a aussi montré que le brossage augmentait l'énergie de collage.

L'enseignement technique particulier que représente la possibilité d'activer une surface par brossage permet de reconsidérer l'importance du brossage dans un procédé de préparation de surface à coller.

En effet, si le brossage n'avait dans l'état de l'art qu'une application de nettoyage de particules présentes en surface de plaquette, il peut, avec l'apport technique apparu à la lumière des mesures faites par la Demanderesse, avoir un rôle bien plus actif dans la préparation des plaquettes avant collage.

De plus, le brossage est en général plus facile, plus simple, plus rapide et plus économique à mettre en oeuvre que d'autres techniques de nettoyage et/ou d'activation de surface, telles que lesdites techniques (1), (2), (3) et (4).

Le choix de placer le brossage en fin de procédé de préparation des plaquettes se justifie donc notamment par le fait qu'il permet de préparer de façon simple et rapide une plaquette au collage, tout en garantissant une amélioration de ses propriétés de collage, de sorte qu'un collage peut être immédiatement envisagé après brossage, sans temps d'attente intermédiaire.

D'autre part, un brossage a une action très douce sur la surface, et provoque pas ou peu de traumatismes sur la surface, comme c'est le cas par exemple d'une abrasion mécanique ou d'une gravure agressive.

En effet, une action maîtrisée du brossage permet d'obtenir un retrait déterminé de matière en surface des plaquettes à coller.

### Exemple 2 :

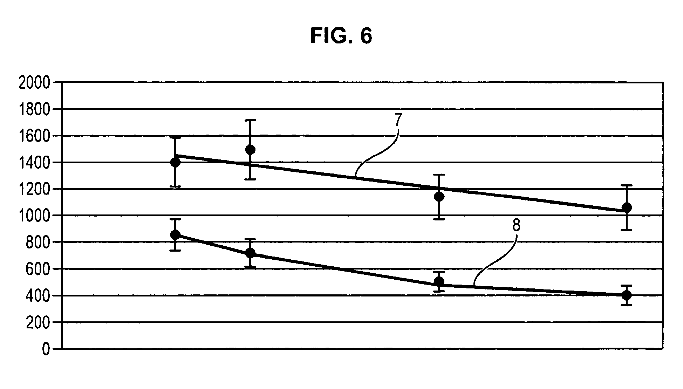

En référence à la figure 6, la Demanderesse a mesuré des énergies de collage entre les deux plaquettes après que leurs surfaces aient subi un traitement par plasma, puis éventuellement un brossage, puis une mise en contact et enfin un traitement thermique.

Ces mesures ont été effectuées sur un certain nombre d'échantillons de plaquettes de silicium, certaines ayant été oxydées, et d'autres non.

De sorte à avoir des surfaces propres, les surfaces des plaquettes à coller ont été préalablement nettoyées, selon par exemple des procédés classiques tels qu'un nettoyage chimique (solution CARO, ozone, RCA, etc.), brossage, etc.

Les plaquettes ont ensuite été soumises à un traitement par plasma en atmosphère d'argon, à une pression de traitement autour de 100 mT d'argon avec un débit.

Après le traitement par plasma, les plaquettes subissent ou non un brossage.

Dans le cas où ces plaquettes ont été brossées, une étape optionnelle consistant à plonger les plaquettes dans un bac d'eau déionisée est prévue entre le traitement par plasma et le brossage.

Après l'étape éventuelle de brossage, les différents échantillons de plaquettes de silicium ont alors chacun été mis en contact avec des plaquettes oxydées pour être collées ensemble.

Les structures ainsi obtenues ont alors été recuites à environ 200°C pendant environ 2 h.

Les mesures des énergies de collage ont été réalisées sur ces structures de façon similaire à celles réalisées dans l'exemple 1 précédent.

En référence à la figure 6, la Demanderesse a effectué des études comparatives d'énergies de collage des plaquettes ayant subi un brossage après le traitement plasma et des plaquettes n'ayant pas subi de brossage après le traitement plasma.

En référence à la figure 6, des résultats de mesures sont présentés de façon graphique, avec en ordonnées des énergies de collage en millijoule par mètre carré, et en abscisses des puissances des radiofréquences (RF) appliquées lors des traitements par plasma.

Les durées des différents traitements par plasma mis ici en oeuvre, ont été les mêmes, de l'ordre de 30 s.

La Demanderesse veut ainsi montrer, non seulement l'influence du brossage sur l'énergie de collage, mais aussi l'influence de la puissance RF choisie sur l'énergie de collage.

La courbe 7 représente les mesures d'énergies de collage dans le cas où un brossage a été mis en oeuvre entre le traitement plasma et le collage.

La courbe 8 représente les mesures d'énergies de collage dans le cas où aucun brossage n'a été mis en oeuvre entre le traitement plasma et le collage.

A partir de la comparaison des courbes 7 et 8, on peut alors constater que la mise en oeuvre d'un brossage entre le traitement plasma et le collage permet d'augmenter l'énergie de collage d'environ 40 % à environ 55 % selon la puissance RF choisie, les résultats variant légèrement selon la puissance RF choisie.

En comparaison, les résultats de l'exemple 1, dans lequel avait été mis en oeuvre un simple brossage avant collage sans traitement plasma préalable, l'augmentation moyenne de l'énergie de collage grâce à un simple brossage était d'environ 20 %.

Ainsi, de façon surprenante, la Demanderesse a mis en évidence que l'augmentation de l'énergie de collage obtenue sous l'influence d'un brossage mis en oeuvre entre un traitement plasma et le collage est au moins le double de celle obtenue sous l'influence d'un simple brossage (sans traitement plasma préalable) mis en oeuvre juste avant collage.

La Demanderesse a ainsi montré que le brossage mis en oeuvre juste avant le collage augmente non seulement l'énergie de collage, mais voit son influence sur l'énergie de collage varier selon les traitements de nettoyage et/ou d'activation énergétique mis en oeuvre au préalable.

En l'espèce, étant donné que le traitement plasma est reconnu comme un des traitements les plus performants pour activer les surfaces de plaquettes à coller, la Demanderesse a ainsi montré qu'en combinant le traitement plasma avec un brossage avant collage, on pouvait atteindre des énergies de collage très élevées (ici de l'ordre de 1 400 mJ/m² avec un plasma d'Argon).

Un autre avantage procuré par une mise en oeuvre d'un brossage juste avant collage dans le cas d'un traitement plasma préalable, est que l'influence de la puissance RF choisie lors du traitement plasma sur l'énergie de collage semble moins forte. Pour obtenir une énergie de collage donnée, on a donc un choix plus grand quant à la puissance RF à utiliser lors du traitement plasma.

## Revendications

1. Procédé de collage de deux plaquettes au niveau de deux surfaces de collage respectives, pour une application dans le domaine de l'électronique, de l'optique et de l'optoélectronique, comprenant les étapes suivantes :
(a) réalisation d'un traitement plasma d'au moins une des surfaces de collage;
(b) brossage d'activation de ladite au moins une surface de collage préalablement activée selon l'étape (a);
(c) mise en contact des surfaces de collage après l'étape (b).

2. Procédé selon la revendication 1, **caractérisé en ce qu'**il comprend, avant l'étape (a), une étape de formation d'une couche de collage sur au moins une des deux surfaces de collage.

3. Procédé selon l'une des deux revendications précédentes, **caractérisé en ce que** l'étape (c) est accompagnée ou suivie d'un traitement thermique apte à renforcer les liaisons de collage.

4. Procédé selon l'une des revendications précédentes, **caractérisé en ce qu'**une étape de nettoyage humide est mise en oeuvre avant l'étape (b).

5. Procédé selon la revendication précédente, **caractérisé en ce que** le nettoyage humide emploie au moins une des espèces chimiques suivantes : ozone, acide fluorhydrique, SC1, SC2, SPM.

6. Procédé selon l'une des revendications 1 à 3, **caractérisé en ce qu'**une étape de nettoyage à sec est mise en oeuvre avant l'étape (b).

7. Procédé selon la revendication précédente, **caractérisé en ce que** le nettoyage sec est à base d'ozone sec.

8. Procédé selon l'une des revendications 1 à 3, **caractérisé en ce qu'**une étape de polissage mécano-chimique est mise en oeuvre avant l'étape (b).

9. Procédé selon l'une des revendications précédentes pour coller une plaquette dite « donneuse » avec une une plaquette dite « réceptrice », **caractérisé en ce qu'**il comporte en outre un prélèvement d'une couche en matériau choisi parmi les matériaux semiconducteurs à partir de la plaquette donneuse selon les étapes suivantes :
- avant l'étape (a), formation d'une zone de fragilisation dans la plaquette donneuse à une profondeur déterminée correspondant sensiblement à une épaisseur de couche mince ;
- après l'étape (c), apport d'énergie au niveau de la zone de fragilisation de sorte à détacher de la plaquette donneuse la couche mince collée à la plaquette réceptrice.

10. Procédé selon la revendication précédente, **caractérisé en ce que** l'étape de formation de la zone de fragilisation est mise en oeuvre par l'une des deux techniques suivantes :
- implantation d'espèces atomiques à une profondeur voisine de la profondeur de la zone de fragilisation ;
- porosification d'une couche au niveau de la zone de fragilisation.

11. Procédé selon l'une des revendications 9 à 10 réalisant une structure semiconducteur sur isolant.

## Patentansprüche

1. Verfahren zum Kleben zweier Plättchen im Bereich zweier jeweils zugehöriger Klebeflächen, und dies für eine Anwendung auf dem Gebiet der Elektronik, Optik und Optoelektronik, die folgenden Schritte umfassend:
a) Ausführen einer Plasmabehandlung wenigstens einer der Klebeflächen;
b) Bürsten, zum Aktivieren, der wenigstens einen Klebefläche, die zuvor gemäß Schritt (a) aktiviert wurde;
c) in Kontakt bringen der Klebeflächen nach Schritt (b).

2. Verfahren nach Anspruch 1, **dadurch gekennzeichnet, dass** es vor Schritt (a) einen Schritt zum Ausbilden einer Klebeschicht auf wenigstens einer der beiden Klebeflächen umfasst.

3. Verfahren nach einem der beiden vorhergehenden Ansprüche, **dadurch gekennzeichnet, dass** begleitend zu Schritt (c) oder auf diesen folgend eine Wärmebehandlung ausgeführt wird, die dafür eingerichtet ist, die Klebeverbindungen zu verstärken.

4. Verfahren nach einem der vorhergehenden Ansprüche, **dadurch gekennzeichnet, dass** vor Schritt (b) ein Schritt zur Nassreinigung ausgeführt wird.

5. Verfahren nach dem vorhergehenden Anspruch, **dadurch gekennzeichnet, dass** die Nassreinigung wenigstens einen der folgenden chemischen Stoffe einsetzt: Ozon, Flusssäure, SC1, SC2, SPM.

6. Verfahren nach einem der Ansprüche 1 bis 3, **dadurch gekennzeichnet, dass** vor Schritt (b) ein Schritt zur Trockenreinigung ausgeführt wird.

7. Verfahren nach dem vorhergehenden Anspruch, **dadurch gekennzeichnet, dass** die Trockenreinigung auf trockenem Ozon basiert.

8. Verfahren nach einem der Ansprüche 1 bis 3, **dadurch gekennzeichnet, dass** vor Schritt (b) ein Schritt zum mechanisch-chemischen Polieren ausgeführt wird.

9. Verfahren nach einem der vorhergehenden Ansprüche zum Verkleben eines als "gebend" bezeichneten Plättchens mit einem als "empfangend" bezeichneten Plättchen, **dadurch gekennzeichnet, dass** es außerdem das Abnehmen einer Schicht aus einem Material umfasst, dass aus den Halbleitermaterialien gewählt ist, und dies ausgehend vom gebenden Plättchen und gemäß den folgenden Schritten:
- vor Schritt (a), Ausbilden einer Schwächungszone im gebenden Plättchen in einer festgelegten Tiefe, die im Wesentlichen einer Dünnschichtdicke entspricht;
- nach Schritt (c), Zuführen von Energie im Bereich der Schwächungszone, und dies derart, dass die am empfangenden Plättchen klebende Dünnschicht vom gebenden Plättchen losgelöst wird.

10. Verfahren nach dem vorhergehenden Anspruch, **dadurch gekennzeichnet, dass** der Schritt zum Ausbilden der Schwächungszone durch eine der beiden folgenden Techniken ausgeführt wird:
- Implantation von Atomsorten in einer Tiefe, die benachbart zur Tiefe der Schwächungszone liegt;
- porös Machen einer Schicht im Bereich der Schwächungszone.

11. Verfahren nach einem der Ansprüche 9 bis 10, das eine Struktur vom Typ Halbleiter-auf-Isolator herstellt.

## Claims

1. A method for bonding two wafers at two respective bonding surfaces, for application in the fields of electronics, optics and optoelectronics, comprising the following steps:
(a) performing plasma treatment on at least one of the bonding surfaces;
(b) activation brushing of the said at least one bonding surface previously activated at step (a);
(c) contacting the bonding surfaces after step (b).

2. The method according to claim 1, **characterized in that** before step (a) it comprises a step of formation of a bonding layer on at least one of the two bonding surfaces.

3. The method according to one of the two preceding claims, **characterized in that** step (c) is accompanied or followed by heat treatment capable of strengthening the bonding bonds.

4. The method according to one of the preceding claims, **characterized in that** a wet cleaning step is conducted before step (b).

5. The method according to the preceding claim, **characterized in that** wet cleaning uses at least one of the following chemical species: ozone, hydrofluoric acid, SC1, SC2, SPM.

6. The method according to one of claims 1 to 3, **characterized in that** a dry cleaning step is conducted before step (b).

7. The method according to the preceding claim, **characterized in that** dry cleaning uses dry ozone.

8. The method according to one of claims 1 to 3, **characterized in that** a chemical-mechanical polishing step is conducted before step (b).

9. The method according to one of the preceding claims to bond a so-called "donor" wafer with a so-called "receiver" wafer, **characterized in that** it further comprises the lifting of a layer of a material chosen from among semiconductive materials, from the donor wafer, using the following steps:
- before step (a), forming a weakened area in the donor wafer at a determined depth substantially corresponding to a thin layer thickness;
- after step (c), bringing energy to the weakened area so as to lift off, from the donor wafer; the thin layer bonded to the receiver wafer.

10. The method according to the preceding claim, **characterized in that** the step to form the weakened area is implemented by using one of the two following techniques:
- implantation of atom species at a depth close to the depth of the weakened area;
- porosification of a layer at the weakened area.

11. The method according to one of claims 9 to 10 to form a semiconductor-on-insulator structure.
